# EUROPEAN PATENT APPLICATION

(11) **EP 3 739 380 A1**
(43) Date of publication of application: **18.11.2020**
(21) Application number: 18852730.3
(22) Date of filing: 07.08.2018
(51) Int. Cl.: G02F 1/1335, G03F 7/027

(54) **PHOTOSENSITIVE COMPOSITION FOR FORMING COLOR RESIST, METHOD FOR MANUFACTURING COLOR FILTER SUBSTRATE, AND COLOR FILTER SUBSTRATE**

(30) Priority: 14.12.2017 CN 201711341225
(71) Applicant: BOE TECHNOLOGY GROUP CO., LTD., Beijing 100015 (CN); Hefei Xinsheng Optoelectronics Technology Co. Ltd, Anhui 230012 (CN)
(72) Inventor: ZHONG, Guoqiang, Beijing 100176 (CN); DONG, Anxin, Beijing 100176 (CN); YIN, Rui, Beijing 100176 (CN); YU, Ya, Beijing 100176 (CN); TANG, Wenhao, Beijing 100176 (CN)
(74) Representative: Jacobacci Coralis Harle
(86) International application number: PCT/CN2018/099212
(87) International publication number: WO 2019/114293

(57) **Abstract**

Embodiments of the present disclosure relate to a photosensitive composition for forming a color resist, a method for manufacturing a color filter substrate, and a color filter substrate. The photosensitive composition includes: at least two color resist precursors; and at least two photoinitiators, each of the at least two photoinitiators being used to initiate polymerization of a corresponding one color resist precursor, of the at least two color resist precursors, to form the color resist.

## Description

### CROSS-REFERENCE TO RELATED APPLICATIONS

This application claims priority of China Patent Application No. 201711341225.3, filed on December 14, 2017, the entire content of which is incorporated herein by reference as part of this application.

### BACKGROUND

Embodiments of the present disclosure relate to the field of display technologies, and in particular, to a photosensitive composition for forming color resist, a method for manufacturing a color filter substrate, and a color filter substrate.

Thin film transistor liquid crystal display (TFT-LCD) is an important planner display device. With the development of the manufacturing technology of displays, the liquid crystal display has developed rapidly, has gradually replaced the traditional kinescope display, and becomes the mainstream of future planner display. Due to the advantages of light weight, small size, no radiation, good energy saving effect, high resolution, etc., liquid crystal displays are widely used in televisions, computers, mobile phones and other fields.

### BRIEF DESCRIPTION

Embodiments of the present disclosure provide a photosensitive composition for forming a color resist, a method for manufacturing a color filter substrate, and a color filter substrate.

According to a first aspect of an embodiment of the present disclosure, there is provided a photosensitive composition for forming a color resist, including: at least two color resist precursors; and at least two photoinitiators. Each of the at least two photoinitiators is used to initiate polymerization of a corresponding one color resist precursor, of the at least two color resist precursors, to form the color resist.

In an embodiment of the present disclosure, sensitive wavelengths of the at least two photoinitiators are different from each other.

In an embodiment of the present disclosure, the sensitive wavelengths of the at least two photoinitiators are in an ultraviolet range.

In an embodiment of the present disclosure, the at least two color resist precursors comprise a monomer material.

In an embodiment of the present disclosure, the at least two color resist precursors comprise a first color resist precursor, a second color resist precursor, and a third color resist precursor, and the at least two photoinitiators comprise a first photoinitiator corresponding to the first color resist precursor, a second photoinitiator corresponding to the second color resist precursor, and a third photoinitiator corresponding to the third color resist precursor.

In an embodiment of the present disclosure, the first color resist precursor is formed by binding a first base monomer material with a first pigment, the first base monomer material comprising CH₂=CHCOOR¹, R¹ of which is a first group for binding a molecule of the first pigment, and wherein the second color resist precursor is formed by binding a second base monomer material with a second pigment, the second base monomer material comprising CR'R²=C(CN)₂, R² of which is a second group for binding a molecule of the second pigment, and wherein the third color resist precursor is formed by binding a third base monomer material with a third pigment, the third base monomer material comprising CR'R³=CH₂, R³ of which is a third group for binding a molecule of the third pigment. R' is a phenyl. The first photoinitiator comprises a thioxanthone molecule, the second photoinitiator comprises a triarylsulfonium salt, and the third photoinitiator comprises a diaryl iodonium salt.

In an embodiment of the present disclosure, the first photoinitiator comprises isopropyl thioxanthone, the second photoinitiator comprises Ar₃SKCl, and the third photoinitiator comprises Ar₂IBF₆ or Ar₂ISbF₆, wherein Ar is an aryl.

In an embodiment of the present disclosure, the first group is MgBr, and the first pigment comprises a pigment R254; the second group is R"OZn, and the second pigment comprises a pigment G58; and the third group is R"OCu, and the third pigment comprises a pigment B 15:6, wherein R" is an alkyl.

According to a second aspect of an embodiment of the present disclosure, there is provided a method for manufacturing a color filter substrate, including: providing a substrate; applying a photosensitive composition for forming a color resist on the substrate; and patterning the photosensitive composition to form at least two color resists. The photosensitive composition comprises at least two color resist precursors and at least two photoinitiators. Each of the at least two photoinitiators is used to initiate polymerization of a corresponding one color resist precursor, of the at least two color resist precursors, to form the color resist.

In an embodiment of the present disclosure, sensitive wavelengths of the at least two photoinitiators are different from each other.

In an embodiment of the present disclosure, the sensitive wavelengths of the at least two photoinitiators are in an ultraviolet range.

In an embodiment of the present disclosure, the patterning comprises: providing at least two masks having different pattern configurations; exposing the photosensitive composition by using light of different wavelengths, respectively, through corresponding one of the at least two masks, wherein the wavelengths of the light used for each exposure are different from each other; and developing the photosensitive composition to form the at least two color resists.

In an embodiment of the present disclosure, the patterning comprises: providing one mask; exposing the photosensitive composition N times through the one mask, wherein N is equal to a number of the at least two photoinitiators; and developing the photosensitive composition to form the at least two color resists. The wavelengths of the light used for each exposure are different from each other. The one mask is moved in a given direction with a given step between two exposures.

In an embodiment of the present disclosure, the at least two color resist precursors comprise a monomer material.

In an embodiment of the present disclosure, the at least two color resist precursors comprise a first color resist precursor, a second color resist precursor, and a third color resist precursor, and the at least two photoinitiators comprise a first photoinitiator corresponding to the first color resist precursor, a second photoinitiator corresponding to the second color resist precursor, and a third photoinitiator corresponding to the third color resist precursor.

In an embodiment of the present disclosure, the first color resist precursor is formed by binding a first base monomer material with a first pigment, the first base monomer material comprising CH₂=CHCOOR¹, R¹ of which is a first group for binding a molecule of the first pigment, and wherein the second color resist precursor is formed by binding a second base monomer material with a second pigment, the second base monomer material comprising CR'R²=C(CN)₂, R² of which is a second group for binding a molecule of the second pigment, and wherein the third color resist precursor is formed by binding a third base monomer material with a third pigment, the third base monomer material comprising CR'R³=CH₂, R³ of which is a third group for binding a molecule of the third pigment. R' is a phenyl. The first photoinitiator comprises a thioxanthone molecule, the second photoinitiator comprises a triarylsulfonium salt, and the third photoinitiator comprises a diaryl iodonium salt.

In an embodiment of the present disclosure, the first group is MgBr, and the first pigment comprises a pigment R254; the second group is R"OZn, and the second pigment comprises a pigment G58; and the third group is R"OCu, and the third pigment comprises a pigment B 15:6, wherein R" is an alkyl.

In an embodiment of the present disclosure, the method further includes: before applying the photosensitive composition, forming an ITO layer on an opposite side of a side, on which the photosensitive composition is to be applied, of the substrate; and forming a patterned black matrix on the side of the substrate.

In an embodiment of the present disclosure, the method further includes: after forming the at least two color resists, forming a planarization layer on a top surface of a structure as formed; and forming a support pillar on the planarization layer.

According to a third aspect of an embodiment of the present disclosure, a color filter substrate is provided. The color filter substrate is manufactured by a method for manufacturing a color filter substrate according to the second aspect of the embodiments of the present disclosure.

In an embodiment of the present disclosure, a photosensitive composition for forming a color resist is provided. Further aspects and regions of applicability will become apparent from the description provided herein. It should be understood that various aspects of this disclosure may be implemented individually or in combination with one or more other aspects. It should also be understood that the description and specific examples herein are intended for purposes of view only and are not intended to limit the scope of the present disclosure.

### BRIEF DESCRIPTION OF THE DRAWINGS

The drawings described herein are for illustrative purposes only of selected embodiments and not all possible implementations, and are not intended to limit the scope of the present disclosure.
FIG. 1 is a partial flowchart of a method for manufacturing a color filter substrate in accordance with an embodiment of the present disclosure;
FIG. 2 is a schematic cross-sectional view of a color filter substrate after applying a photosensitive composition in accordance with a method of an embodiment of the present disclosure;
FIG. 3 is a schematic cross-sectional view of a color filter substrate after forming a first color resist, a second color resist, and a third color resist in accordance with a method of an embodiment of the present disclosure;
FIG. 4 is a flowchart of a method for patterning a photosensitive composition in accordance with a method of an embodiment of the present disclosure;
FIG. 5 is a schematic view of exposing a photosensitive composition in accordance with a method of an embodiment of the present disclosure;
FIG. 6 is a schematic view of exposing a photosensitive composition in accordance with a method of an embodiment of the present disclosure;
FIG. 7 is a schematic view of exposing a photosensitive composition in accordance with a method of an embodiment of the present disclosure;
FIG. 8 is a schematic cross-sectional view of a color filter substrate exposed in accordance with a method of an embodiment of the present disclosure;
FIG. 9 is a flowchart of a method for patterning a photosensitive composition in accordance with a method of an embodiment of the present disclosure;
FIG. 10 is a schematic view of exposing a photosensitive composition in accordance with a method of an embodiment of the present disclosure;
FIG. 11 is a schematic view of exposing a photosensitive composition in accordance with a method of an embodiment of the present disclosure;
FIG. 12 is a schematic view of exposing a photosensitive composition in accordance with a method of an embodiment of the present disclosure;
FIG. 13 is a flowchart of a method for manufacturing a color filter substrate in accordance with an embodiment of the present disclosure;
FIG. 14 is a schematic cross-sectional view of a color filter substrate after forming an ITO layer in accordance with a method of an embodiment of the present disclosure;
FIG. 15 is a schematic cross-sectional view of a color filter substrate after forming a black matrix in accordance with a method of an embodiment of the present disclosure;
FIG. 16 is a schematic cross-sectional view of a color filter substrate after forming a first color resist, a second color resist, and a third color resist in accordance with a method of an embodiment of the present disclosure;
FIG. 17 is a schematic cross-sectional view of a color filter substrate after forming a planarization layer in accordance with a method of an embodiment of the present disclosure; and
FIG. 18 is a schematic cross-sectional view of a color filter substrate after forming a support pillar in accordance with a method of an embodiment of the present disclosure.

Corresponding reference numerals indicate corresponding parts or features throughout the several views of the drawings.

### DETAILED DESCRIPTION

As used herein and in the appended claims, the singular form of a word includes the plural, and vice versa, unless the context clearly dictates otherwise. Thus, the references "a", "an", and "the" are generally inclusive of the plurals of the respective terms. Similarly, the words "comprise", "comprises", and "comprising" are to be interpreted inclusively rather than exclusively. Likewise, the terms "include", "including" and "or" should all be construed to be inclusive, unless such a construction is clearly prohibited from the context. Where used herein the term "examples," particularly when followed by a listing of terms is merely exemplary and illustrative, and should not be deemed to be exclusive or comprehensive.

In addition, it should be noted that, in the description of the present disclosure, the orientations or positions relationship indicated by the terms "upper", "above", "lower", "under", "top", "bottom", "between", etc. are the orientations or positions relationship based on the orientations or positions relationship shown in the drawings, which is merely for the convenience of describing the present disclosure and the simplifing the description, and does not indicate or imply that the referred device or element has to have a specific orientation and is constructed and operated in a specific orientation, therefore, it can not be understood as a limitation to the disclosure. In addition, when an element or a layer is referred to as being "on" another element or layer, the element or the layer can be directly on the another element or layer, or an intermediate element or layer can be present; likewise, when an element or a layer is referred to as being "under" another element or layer, the element or the layer can be directly under another element or layer, or at least one intermediate element or layer can be present; when an element or a layer is referred to as being between two elements or two layers, the element or the layer can be an unique element or layer between the two elements or the two layers, or more than one intermediate element or layer can be present.

The flowchart depicted herein are just one example. There may be many variations to this view or the steps described therein without departing from the spirit of the invention. For instance, the steps may be performed in a differing order or steps may be added, deleted or modified. All of these variations are considered a part of the claimed invention.

Example embodiments will now be described more fully with reference to the accompanying drawings.

At present, when manufacturing a color resist of a color filter substrate, it is necessary to deposit the color resist material multiple times and develop multiple times to finally obtain the color resist, and the process is complicate.

In an embodiment of the present disclosure, a photosensitive composition for forming a color resist is provided. When the photosensitive composition is used for manufacturing a color resist, it is only necessary to apply the color resist material once, and the color resist having different colors can be obtained by one-time developing regardless of how many times being exposed. Thus, the process for manufacturing the color resist can be simplified. Thereby, the process for manufacturing the color filter substrate can be simplified, and the manufacturing cost can be saved.

The photosensitive composition according to an embodiment of the present disclosure may include at least two color resist precursors and at least two photoinitiators. As used herein, the color resist precursor refers to a material capable of forming the color resist by polymerization. Each of the at least two photoinitiators is used to initiate polymerization of a corresponding one color resist precursor, of the at least two color resist precursors, to form the color resist. That is, the photoinitiator is in one-to-one correspondence with the color resist precursor. One photoinitiator can only initiates polymerization of one corresponding color resist precursor.

Specifically, in an embodiment of the present disclosure, the at least two color resist precursors may include a first color resist precursor, a second color resist precursor, and a third color resist precursor. The at least two photoinitiators may include a first photoinitiator corresponding to the first color resist precursor, a second photoinitiator corresponding to the second color resist precursor, and a third photoinitiator corresponding to the third color resist precursor. It should be understood that the number of types of the color resist precursors disclosed in the embodiments of the present disclosure is merely exemplary and should not be construed as a limit to the disclosure. That is, the number of types of the color resist precursors may be two, three or more.

In an embodiment of the present disclosure, the photosensitive composition includes: a first color resist precursor; a first photoinitiator corresponding to the first color resist precursor; a second color resist precursor; a second photoinitiator corresponding to the second color resist precursor; a third color resist precursor; and a third photoinitiator corresponding to the third color resist precursor. It is understood that the ratio of the color resist precursor to the photoinitiator in the photosensitive composition of the present disclosure can be determined according to actual needs, for example, according to the thickness of the color filter or the like. In an embodiment of the present disclosure, the first, second, and third color resist precursors and the first, second, and third photoinitiators are uniformly mixed to obtain the photosensitive composition. Further, the photosensitive composition of the present disclosure may further include a appropriate organic solvent. The color resist precursors, the photoinitiators, and the appropriate organic solvent are soluble with each other and are uniformly mixed to obtain the photosensitive composition.

In an exemplary embodiment of the present disclosure, the first, second, and third color resist precursors may include a monomer material. The first color resist precursor is formed by binding a first base monomer material with a first pigment. In an exemplary embodiment of the present disclosure, the first base monomer material may be an acrylic monomer having a chemical formula of CH₂=CHCOOR¹, wherein R¹ is a first group for binding a molecule of the first pigment. The second color resist precursor is formed by binding a second base monomer material with a second pigment. In an exemplary embodiment of the present disclosure, the second base monomer material may be a vinylidene cyanide monomer having a chemical formula of CR'R²=C(CN)₂, wherein R² is a second group for binding a molecule of the second pigment. The third color resist precursor is formed by binding a third base monomer material with a third pigment. In an exemplary embodiment of the present disclosure, the third base monomer material may be an α-olefin monomer having a chemical formula of CR'R³=CH₂, wherein R³ is a third group for binding a molecule of the third pigment. It is to be noted that R' in the above chemical formula is a phenyl.

It should be noted that, in an exemplary embodiment of the present disclosure, the first, second, and third pigments are, for example, red, green, and blue pigments, respectively.

In an exemplary embodiment of the present disclosure, the first group R¹ may be MgBr; the first pigment may include a pigment R254, i.e., 3,6-Bis(4-chlorophenyl)-2,5-dihydro-pyrrolo[3,4-c]pyrrole-1,4-dione having a molecular formula of C₁₈H₁₀O₂N₂Cl₂, the structural formula of which is as shown in the following formula (1);

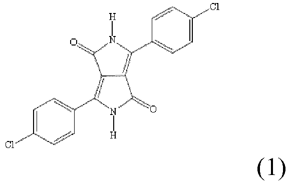

The second group R² may be R"OZn, wherein R" is an organic group, and specifically, R" may be an alkyl; the second pigment may include G58 having a molecular formula of C₃₂N₈Cl₄Br₁₂Zn, the structural formula of which is as shown in the following formula (2) ;

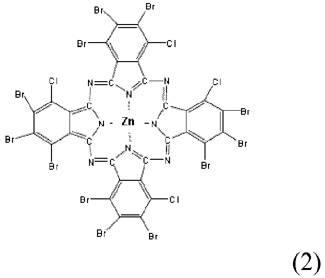

The third group R³ may be R"OCu, wherein, as described above, R" is the organic group, and specifically, R" may be the alkyl; the third pigment may include B15:6 having a molecular formula of C₃₂H₁₆N₈Cu, the structural formula of which is as shown in the following formula (3).

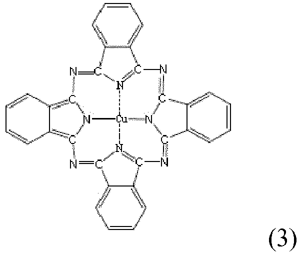

It should be noted that, the first color resist precursor is obtained by binding the first base monomer material with the first pigment, the second color resist precursor is obtained by binding the second base monomer material with the second pigment, and the third color resist precursor is obtained by binding the third base monomer material with the third pigment. Specifically, the first color resist precursor is obtained by binding the first group R¹ in CH₂=CHCOOR¹ with the molecule of the first pigment, that is, obtained by an addition reaction of MgBr with a carbonyl in the pigment R254 (as shown in the above formula (1)). The second color resist precursor is obtained by binding the second group R² in CR'R²=C(CN)₂ with the molecule of the second pigment, that is, obtained by a Zn-Zn metallic bond formed by R"OZn with complex metal Zn atoms in the pigment G58 (as shown in the above formula (2)). The third color resist precursor is obtained by binding the third group R³ in CR'R³=CH₂ with the molecule of the third pigment, that is, obtained by a Cu-Cu metallic bond formed by R"OCu with complex Cu atoms in the pigment B15:6 (as shown in the above formula (3)).

In an exemplary embodiment of the present disclosure, the first photoinitiator capable of initiating polymerization of the above-described first color resist precursor is a thioxanthone molecule, the structural formula of which is as shown in the following formula (4). 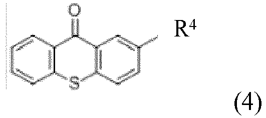 R⁴ is an alkyl or a benzyl. The second photoinitiator capable of initiating polymerization of the above-described second color resist precursor is a triarylsulfonium salt having a molecular formula of Ar₃SMₜXₙ, wherein Ar is an aryl, M may be a non-metallic element such as B, Sb, P, Cl, etc., X may be an element such as F, O, etc., and t and n are integers and are determined by the number of atoms forming a chemical bond. The third photoinitiator capable of initiating polymerization of the third color resist precursor is a diaryl iodonium salt having a molecular formula of Ar₂INₜYₙ, wherein Ar is an aryl, N may be a metallic element such as K, Mg, etc., Y may be a halogen such as Cl, Br, etc., and t and n are integers and are determined by the number of atoms forming a chemical bond.

As an example, the second photoinitiator may be Ar₃SKCl or Ar₃SMgBr. The third photoinitiator may be Ar₃SPF₆, Ar₃SClO₄, Ar₂IBF₆ or Ar₂ISbF₆.

As a specific example, the first photoinitiator is an isopropyl thioxanthone, the structural formula of which is as shown in the following formula (5).

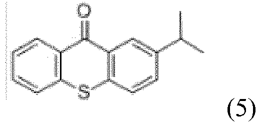

The second photoinitiator is Ar₃SKCl. When Ar is a benzene ring, the second photoinitiator is C₁₈H₁₅SKCl, the name of which is Triphenylsulfonium potassium chloride. The third photoinitiator is Ar₂IBF₆ or Ar₂ISbF₆. When Ar is a benzene ring, the third photoinitiator is C₁₂H₁₀IBF₆, the name of which is diphenyliodonium fluoroborate, or C₁₂H₁₀ISbF₆, the name of which is diphenyliodonium hexafluoroantion.

It should be noted that the sensitive wavelengths of the first, second and third photoinitiators are different from each other. It should be understood that herein, the sensitive wavelength refers to the wavelength of light that is capable of initiating a chemical reaction of the photoinitiator. For example, a photoinitiator undergoes a decomposing reaction under excitation of light having a sensitive wavelength, to generate a decomposed product such as a free radical, a cation or an anion. As an example, the sensitive wavelengths of the first, second and third photoinitiators are in the ultraviolet range. It should be understood that herein, the ultraviolet range refers to the range of ultraviolet light having a wavelength of light of from about 10 nm to about 400 nm.

In an exemplary embodiment of the present disclosure, a method for manufacturing a color filter substrate is also provided. The method can simplify the process of manufacturing the color filter substrate and save manufacturing cost.

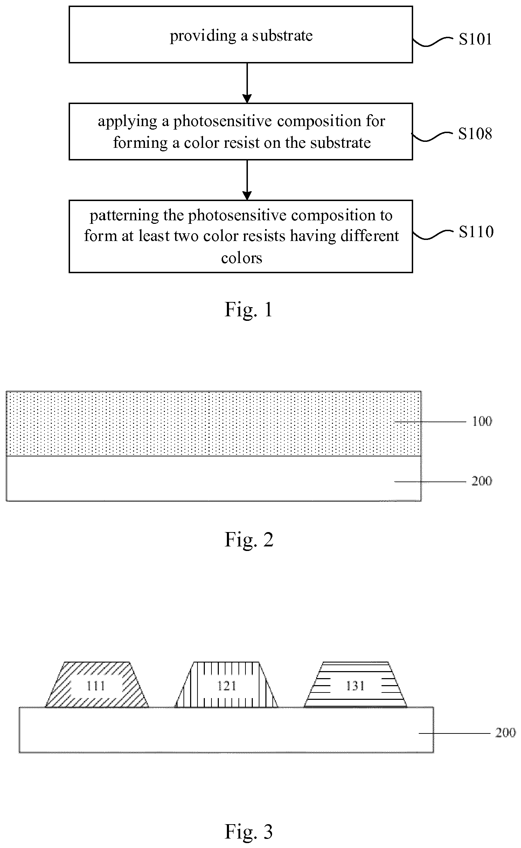

A method for manufacturing a color filter substrate according to an embodiment of the present disclosure will be described in detail below with reference to FIGS. 1 to 18.

FIG. 1 is a partial flowchart of a method for manufacturing a color filter substrate in accordance with an embodiment of the present disclosure. As shown in FIG. 1, in step S101, a substrate is provided; in step S108, a photosensitive composition for forming a color resist is applied on the substrate; and in step S110, the photosensitive composition is patterned to form at least two color resists having different colors.

FIG. 2 is a schematic cross-sectional view of a color filter substrate after applying a photosensitive composition in accordance with a method of an embodiment of the present disclosure. FIG. 3 is a schematic cross-sectional view of a color filter substrate after forming a first color resist, a second color resist, and a third color resist in accordance with a method of an embodiment of the present disclosure. Specifically, as shown in FIG. 2, the photosensitive composition 100 is applied on the substrate 200. As shown in FIG. 3, the photosensitive composition 100 is patterned to form the first, second, and third color resists 111, 121, and 131. It should be noted that, the photosensitive composition 100 has been described in detail above and will not be described again. It should be noted that, in an exemplary embodiment of the present disclosure, the first, second, and third color resists 111, 121, and 131 are red, green, and blue color resists, respectively.

On one hand, the patterning in step S110 may include: providing at least two masks having different pattern configurations; exposing the photosensitive composition by using light of different wavelengths, respectively, through corresponding one of the at least two masks, wherein the wavelengths of the light used for each exposure are different from each other; and developing the photosensitive composition to form the at least two color resists.

Next, a specific process of patterning the photosensitive composition will be described.

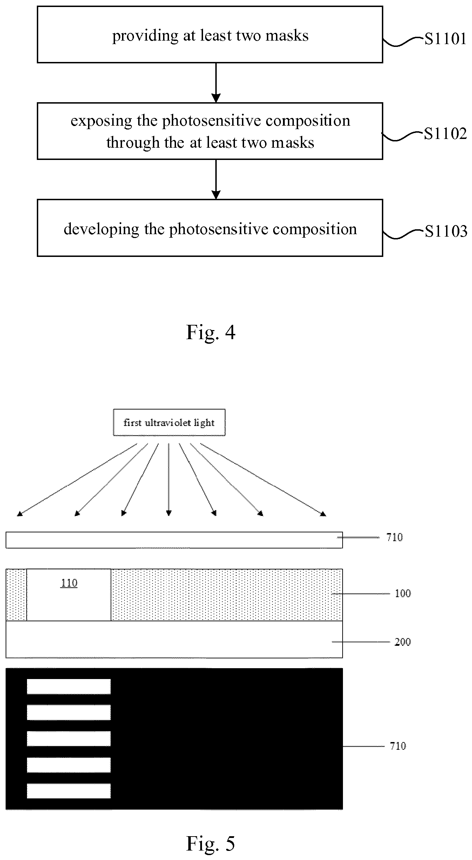

FIG. 4 is a flowchart of a method for patterning a photosensitive composition in accordance with a method of an embodiment of the present disclosure. As shown in FIG. 4, step S110 in FIG. 1 may include: in step S1101, providing at least two masks; in step S1102, exposing the photosensitive composition through the at least two masks; and in step S1103, developing the photosensitive composition.

FIGS. 5 to 7 are schematic views of exposing a photosensitive composition in accordance with a method of an embodiment of the present disclosure. Specifically, in FIG. 5, a first mask 710 having a first pattern is provided. An opening pattern is only designed at a position, of the first mask 710, corresponding to a first region 110 where the first color resist 111 is to be formed. At the time of exposing, the photosensitive composition 100 within the first region 110 is irradiated with a first ultraviolet light. Thus, the first photoinitiator, in the photosensitive composition 100 within the first region 110, is decomposed under the irradiation of the first ultraviolet light to generate a first active species. The first active species initiates the polymerization of the first color resist precursor, such that the first color resist precursor is deposited, thereby the first color resist 111 is formed.

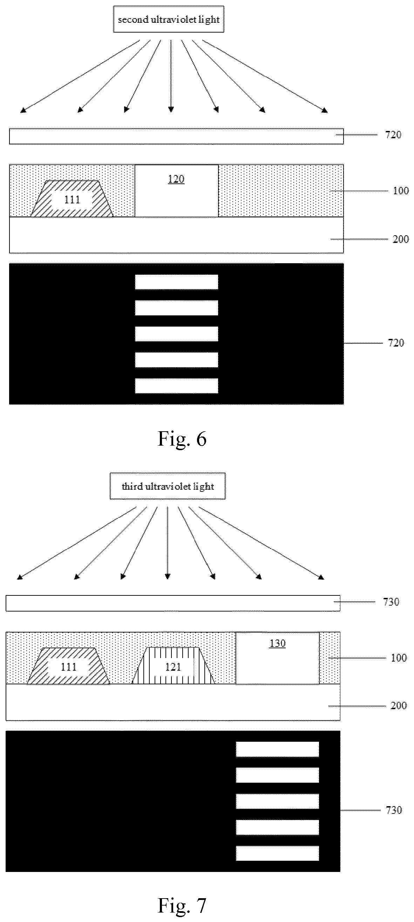

In FIG. 6, a second mask 720 having a second pattern is provided. An opening pattern is only designed at a position, of the second mask 720, corresponding to a second region 120 where the second color resist 121 is to be formed. At the time of exposing, the photosensitive composition 100 within the second region 120 is irradiated with a second ultraviolet light. Thus, the second photoinitiator, in the photosensitive composition 100 within the second region 120, is decomposed under the irradiation of the second ultraviolet light to generate a second active species. The second active species initiates the polymerization of the second color resist precursor, such that the second color resist precursor is deposited, thereby the second color resist 121 is formed.

In FIG. 7, a third mask 730 having a third pattern is provided. An opening pattern is only designed at a position, of the third mask 730, corresponding to a third region 130 where the third color resist 131 is to be formed. At the time of exposing, the photosensitive composition 100 within the third region 130 is irradiated with a third ultraviolet light. Thus, the third photoinitiator, in the photosensitive composition 100 within the third region 130, is decomposed under the irradiation of the third ultraviolet light to generate a third active species. The third active species initiates the polymerization of the third color resist precursor, such that the third color resist precursor is deposited, thereby the third color resist 131 is formed.

It should be noted that the designed patterns of the first, second, and third masks may be the same or different, which is not specifically limited in this disclosure.

It should be noted that the wavelengths of the first, second, and third ultraviolet lights are different from each other. The first ultraviolet light can only make the first photoinitiator corresponding to it decompose to generate the first active species. The second ultraviolet light can only make the second photoinitiator corresponding to it decompose to generate the second active species. The third ultraviolet light can only make the third photoinitiator corresponding to it decompose to generate the third active species. In addition, the first active species can only polymerize with its corresponding first color resist precursor. The second active species can only polymerize with its corresponding second color resist precursor. The third active species can only polymerize with its corresponding third color resist precursor.

According to the foregoing, in an exemplary embodiment of the present disclosure, when the first photoinitiator is isopropyl thioxanthone (as shown in the above formula (5)), the first active species generated by the decomposing of isopropyl thioxanthone under the irradiation of the first ultraviolet light, having the wavelength from about 380 nm to about 400 nm, is an isopropyl thioxanthone intermediate, the structural formula of which is as shown in the following formula (6).

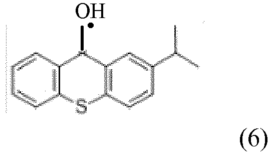

When the second photoinitiator is Ar₃SKCl, the second active species generated by the decomposing of Ar₃SKCl under the irradiation of the second ultraviolet light, having the wavelength from about 244 nm to about 264 nm, is KCl-OH. When the third photoinitiator is Ar₂IBF₆ or Ar₂ISbF₆, the third active species generated by the decomposing of Ar₂IBF₆ or Ar₂ISbF₆ under the irradiation of the third ultraviolet light, having the wavelength from about 217 nm to about 237 nm, is HBF₆ or HSbF₆. As described above, Ar is the aryl.

It should be noted that the above first, second, and third active species are only present during the polymerization process and are not present separately in the final product.

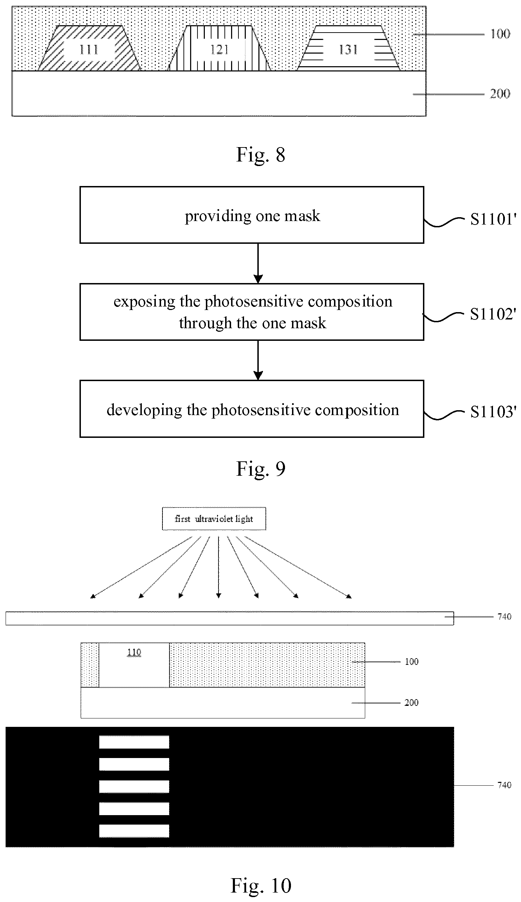

FIG. 8 is a schematic cross-sectional view of a color filter substrate exposed in accordance with a method of an embodiment of the present disclosure. As shown in FIG. 8, the first, second, and third color resist precursors in which the polymerization occurs are deposited to form the first, second, and third color resists 111, 121, and 131.

Then, as described in step S1103, the unexposed portion of the photosensitive composition 100 in FIG. 8 is developed, thereby a structure as shown in FIG. 3 is formed.

On the other hand, in the case where the patterns of the color resists having different colors to be manufactured are the same, the patterning in step S110 may include: providing one mask; exposing the photosensitive composition N times through the one mask, wherein N is equal to the number of the at least two photoinitiators; and developing the photosensitive composition to form the at least two color resists. The wavelengths of light used for each exposure are different from each other. The one mask is moved in a given direction with a given step between two exposures.

Next, a specific process of patterning the photosensitive composition will be described.

FIG. 9 is a flowchart of a method for patterning a photosensitive composition in accordance with a method of an embodiment of the present disclosure. As shown in FIG. 9, step S110 in FIG. 1 may include: in step S1101', providing one mask; in step S1102', exposing the photosensitive composition through the one mask; and in step S1103', developing the photosensitive composition.

It should be noted that only one mask is used in this embodiment, and the mask may have a lateral dimension larger than a lateral dimension of the color filter substrate to be manufactured. The pattern of the mask is suitable for the color resists having different colors.

FIGS. 10 to 12 are schematic views of exposing a photosensitive composition in accordance with a method of an embodiment of the present disclosure. In an exemplary embodiment of the present disclosure, a fourth mask having a fourth pattern is provided. The photosensitive composition was exposed N times through the fourth mask, where N is equal to the number of the at least two photoinitiators. As an example, the photosensitive composition is exposed three times through the fourth mask.

Specifically, in FIG. 10, a fourth mask 740 having a fourth pattern is provided. An opening of the fourth mask 740 is aligned with the first region 110 where the first color resist 111 is to be formed. The photosensitive composition 100 within the first region 110 is irradiated with the first ultraviolet light. Thus, the first photoinitiator, in the photosensitive composition 100 within the first region 110, is decomposed under the irradiation of the first ultraviolet light to generate the first active species. The first active species then initiates the polymerization of the first color resist precursor, such that the first color resist precursor is deposited, thereby the first color resist 111 is formed.

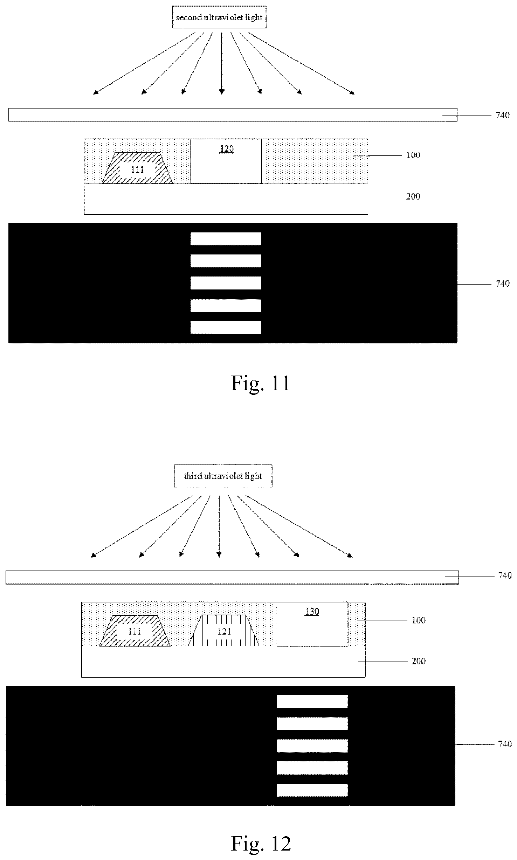

In FIG. 11, the opening of the fourth mask 740 is aligned with the second region 120 where the second color resist 121 is to be formed. The photosensitive composition 100 within the second region 120 is irradiated with the second ultraviolet light. Thus, the second photoinitiator, in the photosensitive composition 100 within the second region 120, is decomposed under the irradiation of the second ultraviolet light to generate the second active species. The second active species then initiates the polymerization of the second color resist precursor, such that the second color resist precursor is deposited, thereby the second color resist 121 is formed.

In FIG. 12, the opening of the fourth mask 740 is aligned with the third region 130 where the third color resist 131 is to be formed. The photosensitive composition 100 in the third region 130 is irradiated with the third ultraviolet light. Thus, the third photoinitiator, in the photosensitive composition 100 within the third region 130, is decomposed under the irradiation of the third ultraviolet light to generate the third active species. The third active species then initiates the polymerization of the third color resist precursor, such that the third color resist precursor is deposited, thereby the third color resist 131 is formed.

Thereby, the structure as shown in FIG. 8 is obtained. That is, the first, second, and third color resist precursors in which the polymerization occurs are deposited to form the first, second, and third color resists 111, 121, and 131.

Then, as described in step S1103', the unexposed portion of the photosensitive composition 100 in FIG. 8 is developed, thereby the structure shown in FIG. 3 is formed.

It should be noted that the fourth mask is moved in a given direction with a given step length between two exposures. The present disclosure does not specifically limit the size of the step and the specific moving direction. The size of the step and the moving direction can be determined according to actual needs.

It should be noted that the process of exposing has been described in detail in the text above and will not be described here.

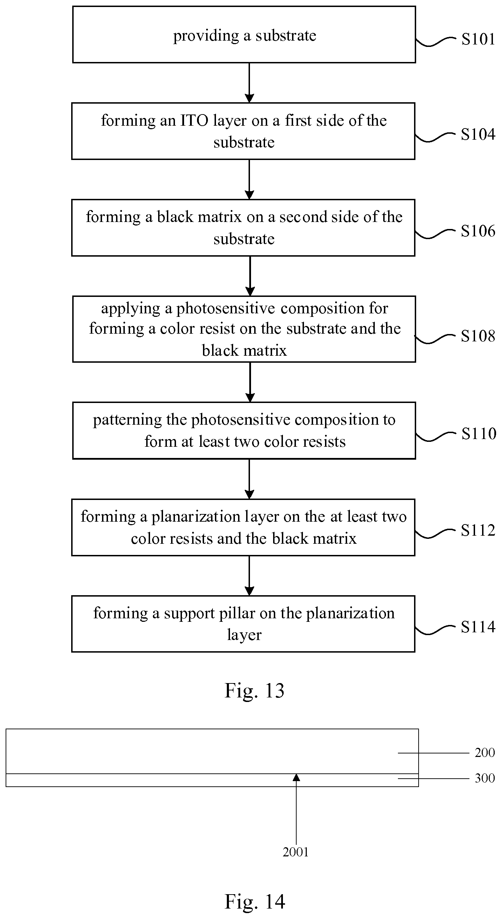

FIG. 13 is a flowchart of a method for manufacturing a color filter substrate in accordance with an embodiment of the present disclosure. As shown in FIG. 13, after step S101 and before step S108, the method further includes: in step S104, forming an ITO layer on a first side of the substrate; and in step S106, forming a black matrix on a second side of the substrate.

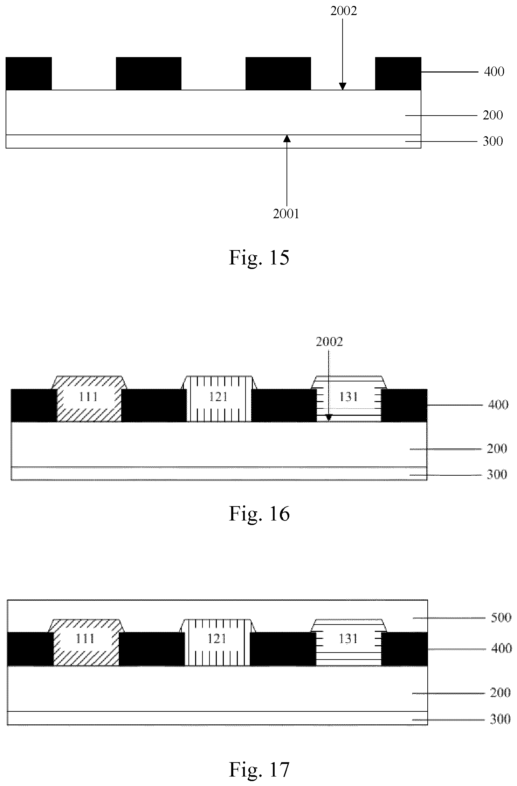

FIG. 14 is a schematic cross-sectional view of a color filter substrate after forming an ITO layer in accordance with a method of an embodiment of the present disclosure. FIG. 15 is a schematic cross-sectional view of a color filter substrate after forming a black matrix in accordance with a method of an embodiment of the present disclosure. As shown in FIG. 14, an ITO layer 300 is formed on a first side 2001 of the substrate 200. The first side 2001 is the opposite side of a side on which the photosensitive composition is to be applied. As shown in FIG. 15, a patterned black matrix 400 is formed on a second side 2002 of the substrate 200. The second side 2002 is a side on which the photosensitive composition is to be applied.

Next, as described above, the patterned at least two color resists are formed on the substrate 200. FIG. 16 is a schematic cross-sectional view of a color filter substrate after forming a first color resist, a second color resist, and a third color resist in accordance with a method of an embodiment of the present disclosure. Specifically, as shown in FIG. 16, a first color resist 111, a second color resist 121, and a third color resist 131 are formed on the second side 2002 of the substrate 200 and on the black matrix 400.

Next, as shown in FIG. 13, after step S110, that is, after forming the at least two color resists, the method further includes: in S112, forming a planarization layer on the at least two color resists and the black matrix; and in S114, forming a support pillar on the planarization layer.

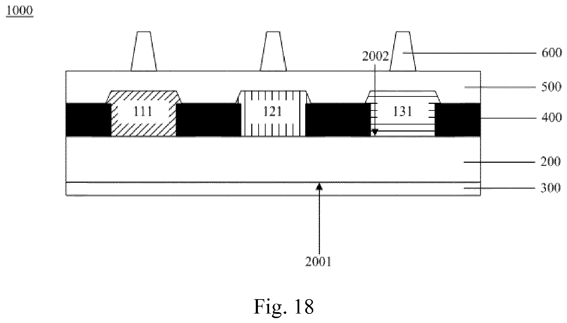

FIG. 17 is a schematic cross-sectional view of a color filter substrate after forming a planarization layer in accordance with a method of an embodiment of the present disclosure. FIG. 18 is a schematic cross-sectional view of a color filter substrate after forming a support pillar in accordance with a method of an embodiment of the present disclosure. As shown in FIG. 17, a planarization layer 500 is formed on the first, second, and third color resists 111, 121, and 131 and on the black matrix 400. As shown in FIG. 18, a patterned support pillar 600 is formed on the planarization layer 500.

In an exemplary embodiment of the present disclosure, a color filter substrate is also provided. The color filter substrate is manufactured by the method for manufacturing a color filter substrate as described above. As shown in FIG. 18, the color filter substrate 1000 includes: a substrate 200; an ITO layer 300 on a first side 2001 of the substrate 200; a black matrix 400 on the second side 2002 of the substrate 200; a first color resist 111, a second color resist 121, and a third color resist 131 on the second side of the substrate 200 and on the black matrix 400; a planarization layer 500 on the black matrix 400 and the first, second, and third color resists 111, 121, and 131; and a support pillar 600 on the planarization layer 500.

In an embodiment of the present disclosure, a photosensitive composition for forming a color resist is provided. When the photosensitive composition is used for manufacturing the color resist, it is only necessary to apply a color resist material once, and the color resists having different colors can be obtained by one-time developing how many times being exposed. In an embodiment of the present disclosure, there is also provided a method for manufacturing a color filter substrate, which utilizes the above-described photosensitive composition to form color resists having different colors, thereby simplifying the process of manufacturing a color filter substrate and saving manufacturing costs.

The foregoing description of the embodiments has been provided for purpose of view and description. It is not intended to be exhaustive or to limit the disclosure. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are included within the scope of the disclosure.

## Claims

1. A photosensitive composition for forming a color resist, comprising:
at least two color resist precursors; and
at least two photoinitiators, each of the at least two photoinitiators being used to initiate polymerization of a corresponding one color resist precursor, of the at least two color resist precursors, to form the color resist.

2. The photosensitive composition according to claim 1, wherein sensitive wavelengths of the at least two photoinitiators are different from each other.

3. The photosensitive composition according to claim 2, wherein the sensitive wavelengths of the at least two photoinitiators are in an ultraviolet range.

4. The photosensitive composition according to claim 1, wherein the at least two color resist precursors comprise a monomer material.

5. The photosensitive composition according to claim 4, wherein the at least two color resist precursors comprise a first color resist precursor, a second color resist precursor, and a third color resist precursor, and the at least two photoinitiators comprise a first photoinitiator corresponding to the first color resist precursor, a second photoinitiator corresponding to the second color resist precursor, and a third photoinitiator corresponding to the third color resist precursor.

6. The photosensitive composition according to claim 5, wherein the first color resist precursor is formed by binding a first base monomer material with a first pigment, the first base monomer material comprising CH₂=CHCOOR¹, R¹ of which is a first group for binding a molecule of the first pigment, and wherein the second color resist precursor is formed by binding a second base monomer material with a second pigment, the second base monomer material comprising CR'R²=C(CN)₂, R² of which is a second group for binding a molecule of the second pigment, and wherein the third color resist precursor is formed by binding a third base monomer material with a third pigment, the third base monomer material comprising CR'R³=CH₂, R³ of which is a third group for binding a molecule of the third pigment, and wherein R' is a phenyl,
wherein the first photoinitiator comprises a thioxanthone molecule, the second photoinitiator comprises a triarylsulfonium salt, and the third photoinitiator comprises a diaryl iodonium salt.

7. The photosensitive composition according to claim 6, wherein the first photoinitiator comprises isopropyl thioxanthone, the second photoinitiator comprises Ar₃SKCl, and the third photoinitiator comprises Ar₂IBF₆ or Ar₂ISbF₆, wherein Ar is an aryl.

8. The photosensitive composition according to claim 7, wherein the first group is MgBr, and the first pigment comprises a pigment R254; the second group is R"OZn, and the second pigment comprises a pigment G58; and the third group is R"OCu, and the third pigment comprises a pigment B 15:6, wherein R" is an alkyl.

9. A method for manufacturing a color filter substrate, comprising:
providing a substrate;
applying a photosensitive composition for forming a color resist on the substrate, wherein the photosensitive composition comprises at least two color resist precursors and at least two photoinitiators, each of the at least two photoinitiators being used to initiate polymerization of a corresponding one color resist precursor, of the at least two color resist precursors, to form the color resist; and
patterning the photosensitive composition to form at least two color resists having different colors.

10. The method according to claim 9, wherein sensitive wavelengths of the at least two photoinitiators are different from each other.

11. The method according to claim 10, wherein the sensitive wavelengths of the at least two photoinitiators are in an ultraviolet range.

12. The method according to claim 10, wherein the patterning comprises:
providing at least two masks having different pattern configurations;
exposing the photosensitive composition by using light of different wavelengths, respectively, through corresponding one of the at least two masks, wherein the wavelengths of the light used for each exposure are different from each other; and
developing the photosensitive composition to form the at least two color resists.

13. The method according to claim 10, wherein the patterning comprises:
providing one mask;
exposing the photosensitive composition N times through the one mask, wherein N is equal to a number of the at least two photoinitiators, and wherein the wavelengths of the light used for each exposure are different from each other, and wherein the one mask is moved in a given direction with a given step between two exposures; and
developing the photosensitive composition to form the at least two color resists.

14. The method according to claim 9, wherein the at least two color resist precursors comprise a monomer material.

15. The method according to claim 14, wherein the at least two color resist precursors comprise a first color resist precursor, a second color resist precursor, and a third color resist precursor, and the at least two photoinitiators comprise a first photoinitiator corresponding to the first color resist precursor, a second photoinitiator corresponding to the second color resist precursor, and a third photoinitiator corresponding to the third color resist precursor.

16. The method according to claim 15, wherein the first color resist precursor is formed by binding a first base monomer material with a first pigment, the first base monomer material comprising CH₂=CHCOOR¹, R¹ of which is a first group for binding a molecule of the first pigment, and wherein the second color resist precursor is formed by binding a second base monomer material with a second pigment, the second base monomer material comprising CR'R²=C(CN)₂, R² of which is a second group for binding a molecule of the second pigment, and wherein the third color resist precursor is formed by binding a third base monomer material with a third pigment, the third base monomer material comprising CR'R³=CH₂, R³ of which is a third group for binding a molecule of the third pigment, and wherein R' is a phenyl,
wherein the first photoinitiator comprises a thioxanthone molecule, the second photoinitiator comprises a triarylsulfonium salt, and the third photoinitiator comprises a diaryl iodonium salt.

17. The method according to claim 16, wherein the first group is MgBr, and the first pigment comprises a pigment R254; the second group is R"OZn, and the second pigment comprises a pigment G58; and the third group is R"OCu, and the third pigment comprises a pigment B 15:6, wherein R" is an alkyl.

18. The method according to claim 9, further comprising: before applying the photosensitive composition, forming an ITO layer on an opposite side of a side, on which the photosensitive composition is to be applied, of the substrate; and
forming a patterned black matrix on the side of the substrate.

19. The method according to claim 18, further comprising: after forming the at least two color resists, forming a planarization layer on a top surface of a structure as formed; and
forming a support pillar on the planarization layer.

20. A color filter substrate manufactured by the method for manufacturing a color filter substrate according to any one of claims 9 to 19.
